(19) Europäisches Patentamt
European Patent Office
Office européen des brevets

(11) Veröffentlichungsnummer: **0 291 881 B1**

(12) # EUROPÄISCHE PATENTSCHRIFT

(45) Veröffentlichungstag der Patentschrift: **23.12.92**

(51) Int. Cl.$^5$: **G03F 7/031**

(21) Anmeldenummer: **88107721.8**

(22) Anmeldetag: **13.05.88**

(54) **Photopolymerisierbare Aufzeichnungsmaterialien sowie Photoresistschichten und Flachdruckplatten auf Basis dieser Aufzeichnungsmaterialien.**

(30) Priorität: **21.05.87 DE 3717037**

(43) Veröffentlichungstag der Anmeldung:
**23.11.88 Patentblatt 88/47**

(45) Bekanntmachung des Hinweises auf die Patenterteilung:
**23.12.92 Patentblatt 92/52**

(84) Benannte Vertragsstaaten:
**BE CH DE FR GB IT LI NL SE**

(56) Entgegenhaltungen:
**DE-A- 2 046 018**
**DE-A- 3 433 026**
**DE-A- 3 517 173**

(73) Patentinhaber: **BASF Aktiengesellschaft**
**Carl-Bosch-Strasse 38**
**W-6700 Ludwigshafen(DE)**

(72) Erfinder: **Boettcher, Andreas, Dr.**
**Breslauer Strasse 24**
**W-6906 Leimen(DE)**
Erfinder: **Fischer, Martin, Dr.**
**Elbinger Weg 1**
**W-6700 Ludwigshafen(DE)**
Erfinder: **Aldag, Reinhard, Dr.**
**Gunterstrasse 22**
**W-6700 Ludwigshafen(DE)**
Erfinder: **Bluemel, Thomas, Dr.**
**An der Bleiche 12 a**
**W-6701 Erpolzheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft photopolymerisierbare Aufzeichnungsmaterialien mit mindestens einer photopolymerisierbaren, olefinisch ungesättigten organischen Verbindung, gegebenenfalls einem polymeren Bindemittel, einem Photopolymerisationsinitiator, einem farbbildenden System, bestehend aus Farbbildner und Photooxidationsmittel, sowie einem Sensibilisator. Sie sind insbesondere geeignet für die Herstellung von Photoresistschichten und Flachdruckplatten.

Photopolymerisierbare Aufzeichnungsmaterialien für die genannten Anwendungszwecke sind an sich bekannt. Sie enthalten im allgemeinen neben einer photopolymerisierbaren, olefinisch ungesättigten organischen Verbindung, einem polymeren Bindemittel sowie einem Photopolymerisationsinitiator ein farbbildendes System, welches bei Bestrahlung mit aktinischem Licht in den bestrahlten Bereichen eine Farbänderung bewirkt. Diese Farbänderung ist für die visuelle Beurteilung und Kontrolle der Aufzeichnungsmaterialien nach der bildmäßigen Belichtung von großer Wichtigkeit. So ist es z.B. bei der Herstellung gedruckter Schaltungen oder Leiterplatten mittels Photoresistschichten notwendig, sich nach der bildmäßigen Belichtung und vor der Entfernung der unbelichteten Bereiche der Photoresistschichten zu vergewissern, ob das Negativ richtig aufgelegt war und eine korrekte Belichtungszeit gewählt wurde. Ferner ermöglicht die Farbänderung bei der bildmäßigen Belichtung von Schichten aus den photopolymerisierbaren Aufzeichnungsmaterialien eine Kontrolle des erhaltenen Bildes nach der Entwicklung der belichteten Schicht, so daß hierdurch beispielsweise etwaige Ablösungen der Bildteile der Schicht bei der Entwicklung leicht und zuverlässig festgestellt werden können. Um eine gute visuelle Beurteilung dieser belichteten Schichten vornehmen zu können, soll das farbbildende System bei der Belichtung einen möglichst starken Farbkontrast in den Aufzeichnungsmaterialien bewirken, d.h. es sollen durch die Farbbildung möglichst dunkle Bilder bei Betrachtung im Gelblicht entstehen. Ferner müssen die farbbildenden Systeme thermisch lagerstabil sein, damit in den photopolymerisierbaren Aufzeichnungsmaterialien in der Zeit zwischen Herstellung und Anwendung keine unerwünschte Farbvertiefung auftritt.

Die farbbildenden Systeme bestehen im allgemeinen aus einer farblosen oder schwach gefärbten Farbstoff-Vorstufe (Farbbildner) und einem Aktivator, der bei Bestrahlung mit aktinischem Licht die Farbstoff-Vorstufe in die farbige Verbindung überführt. Als Farbbildner kommen insbesondere Leukofarbstoffe, die schwach gefärbten freien Basen oder Lactonformen von Farbstoffen in Betracht. Als Aktivatoren für die Farbbildner werden üblicherweise Photooxidationsmittel eingesetzt, wobei hierfür insbesondere organische Halogenverbindungen beschrieben werden, die bei Bestrahlung mit aktinischem Licht Halogenradikale abspalten. Verwiesen sei in diesem Zusammenhang z.B. auf die DE-A-23 06 353, DE-A-27 18 200, EP-B-2805, EP-B-5379 sowie WO-A-80/01846. Es ist auch schon vorgeschlagen worden (z.B. DOS 34 33 026) Azidverbindungen, wie 2-Azidobenzoxazol, Benzoylazid und 2-Azidobenzimidazol (US-A-3 282 693), Triazole und heterocyclische Ketimide (GB 1 030 887) sowie Hexaarylbisimidazole (vgl. DE-A-19 24 317 sowie EP-B-19219) als Photooxidationsmittel zu verwenden. Von den bekannten photopolymerisierbaren Aufzeichnungsmaterialien, die insbesondere den zuletzt genannten Photooxidantientyp enthalten, weisen einige daüber hinaus zur Empfindlichkeitssteigerung und Verbesserung der Photoreaktion auch noch einen Sensibilisator, z.B. ein tertiäres Amin einer aromatischen Carbonylverbindung, wie z.B. Michler's Keton, auf.

Die in den bekannten photopolymerisierbaren Aufzeichnungsmaterialien eingesetzten farbbildenden Systeme zeigen bei der bildmäßigen Belichtung dieser Materialien mit aktinischem Licht häufig nur einen schwachen Farbumschlag und einen nicht zufriedenstellenden Kontrast zwischen belichteten und unbelichteten Bereichen. Auch ist die Lagerstabilität der bisher für die photopolymerisierbaren Aufzeichnungsmaterialien verwendeten farbbildenden Systeme vielfach nicht zufriedenstellend, so daß bereits bei der Lagerung im Dunkeln eine Farbvertiefung zu beobachten ist. Die farbbildenden Systeme, die als Aktivator für den Farbbildner eine organische Halogenverbindung enthalten, beeinflussen ferner den Verarbeitungsspielraum der photopolymerisierbaren Aufzeichnungsmaterialien in negativer Weise. So lassen sich Photoresistschichten aus diesen Aufzeichnungsmaterialien beispielsweise nach der bildmäßigen Belichtung und Entwicklung nicht vollständig von metallischen Substraten entfernen, wie es z.B. bei der Herstellung von gedruckten Schaltungen und Leiterplatten erforderlich ist, sondern es verbleibt eine mehr oder weniger stark ausgebildete Restschicht auf dem Substrat, die die Weiterverarbeitung der Produkte stört. Weiterhin kann der Halogengehalt zu Korrosionserscheinungen an metallischen Substraten führen. Die ferner auch verwendeten Hexaarylbisimidazole, die bei Bestrahlung der photopolymerisierbaren Aufzeichnungsmaterialien mit aktinischem Licht gleichermaßen die Photopolymerisation wie auch die Photooxidation initiieren, sind nur in aufwendiger Weise herzustellen und erlauben aufgrund der Lage des langwelligen Absorptionsmaximums nur die Verwendung spezieller Strahlungsquellen. Außerdem lassen sich hier Photopolymerisations- und Photooxidationsverhalten in den photopolymerisierbaren Aufzeichnungsmaterialien ohne Verwendung weiterer Hilfsstoffe nicht unabhängig voneinander variieren. Es besteht daher ein Bedarf an weiteren, verbesserten farbbildenden Systemen für den Einsatz in photopolymerisierbaren Aufzeichnungsmaterialien der in Rede stehenden Art.

Ein auf einen Schichtträger aufgebrachtes farbbildendes System ist in der DE-A-20 46 018 beschrieben. Dieses photographische, nicht photopolymerisierbare Aufzeichnungsmaterial dient zur Herstellung von gefärbten Bildern. Ihr Farbbildner-System besteht aus einem farblosen oder praktisch farblosen Farbbildner, der oxidativ in die gefärbte Form überführt werden kann, sowie einer heterocyclischen Verbindung mit einem durch einen Acyloxy- oder Alkoxy-Rest substituierten Ringstickstoffatom als Photooxidationsmittel. Als Farbbildner werden Leukofarbstoffe und deren Derivate beschrieben. Als Photooxidationsmittel sind speziell substituierte N-Alkoxy- bzw. N-Acyloxy-pyridinium-Salze genannt. Durch die Substituenten im Pyridinium-Rest wird das langwellige Absorptionsmaximum des Aktivators den jeweils verwendeten Strahlungsquellen angepaßt, d.h. das für den Leukofarbstoff als Photooxidationsmittel (Aktivator) eingesetzte Pyridiniumsalz absorbiert bevorzugt aktinisches Licht mit einer Wellenlänge größer 400 nm. In der DOS 34 33 026 wird als Farbbildner-System ebenfalls ein Alkoxypyridiniumsalz mit einem speziellen Leukofarbstoff beschrieben. N-Alkoxypyridiniumsalze werden auch als Photopolymerisationsinitiatoren allein (vgl. DOS 19 50 746, DOS 19 50 749, US-Re-27 925 oder US-P-3 574 622) oder in Kombination mit einem Ketocumarin als Sensibilisator für aktinisches Licht einer Wellenlänge > 400 nm beansprucht (vgl. DOS 31 35 399). Als Stand der Technik ergibt sich somit, daß N-Alkoxy-pyridiniumsalze allein als Photooxidantien oder Photopolymerisationsinitiatoren wirken und durch Ketocumarine sensibilisiert werden können. Die zur Erzielung eines nach dem Stand der Technik erforderlichen Polymerisationsgrades notwendigen Belichtungszeiten sind bei dem vorstehend genannten Initiatorsystem nicht wesentlich von denen mit dem industriell eingesetzten Polymerisationsinitiator Michler's Keton/Benzophenon erzielten Zeiten verschieden. Die in der DE-A-20 46 018 beschriebenen photographischen Aufzeichnungsmaterialien zeigen bei Belichtung mit aktinischem Licht nur einen relativ schwachen Farbumschlag bzw. benötigen für die Erzielung eines stärkeren Kontrastes zwischen belichteten und unbelichteten Bereichen wesentlich längere Belichtungszeiten, als sie für photopolymerisierbare Aufzeichnungsmaterialien akzeptierbar sind.

Aufgabe der vorliegenden Erfindung war es, photopolymerisierbare Aufzeichnungsmaterialien mit einem guten Farbbildner-System aufzuzeigen, die die Nachteile der bisher bekannten Produkte überwinden, d.h. die einfach und leicht erhältlich sind, bei denen die für die photopolymerisierbaren Aufzeichnungsmaterialien geforderten relativ kurzen Belichtungzeiten mit aktinischem Licht einen großen Farbumschlag unter Ausbildung eines scharfen und starken Kontrastes zwischen belichteten und unbelichteten Bereichen liefern, die gute Lagerstabilität besitzen sowie auf metallischen Substraten keine Restschicht bilden.

Es wurde überraschenderweise gefunden, daß diese Aufgabe mit speziellen Photooxidationsmitteln besser gelöst wird.

Gegenstand der Erfindung sind dementsprechend photopolymerisierbare Aufzeichnungsmaterialien mit mindestens einer photopolymerisierbaren, olefinisch ungesättigten organischen Verbindung, gegebenenfalls einem polymeren Bindemittel, mindestens einem Photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, die als farbbildendes System

(a) mindestens eine farblose oder praktisch farblose organische Verbindung, die zu einer farbigen Verbindung oxidierbar ist, und

(b) als Photooxidationsmittel für die farblose oder praktisch farblose organische Verbindung (a) ein organisches Salz eines, gegebenenfalls substituierten, stickstoffhaltigen heteroaromatischen Systems mit mindestens einer Gruppierung der allgemeinen Formel (I)

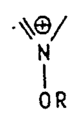

(I)

enthalten,

die dadurch gekennzeichnet sind, daß in dem als Photooxidationsmittel einzusetzenden organischen Salz mit einem, gegebenenfalls substituierten, heteroaromatischen System mit der Gruppierung der allgemeinen Formel (I) R einen gegebenenfalls substituierten Alkenyl-, Alkinyl-, Hetaryl-, Alkencarbonyl-, Alkincarbonyl-, Alkoxycarbonyl-, Carbamoyl-, Alkylsulfonyl-, Arylsulfonylaminosulfinyl-Rest oder einen substituierten Cycloalkyl-Rest sowie ein gegebenenfalls substituiertes Hetarylkation darstellt, mit der Maßgabe, daß das Maximum der langwelligen Absorptionsbande dieses Salzes unter 400 nm liegt, Gegenstand der Erfindung

sind außerdem insbesondere Aufzeichnungsmaterialien, die als Sensibilisator eine Verbindung der allgemeinen Formel (III)

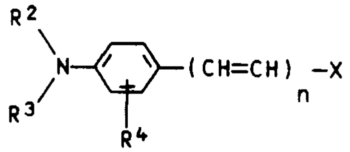

(III)

enthalten, worin
$R^2$ und $R^3$ gleich oder verschieden sein können und stehen für eine gegebenenfalls substituierte Alkylgruppe mit 1 bis 6 Kohlenstoffatomen, eine Phenylgruppe oder eine Aralkyl-Gruppe. $R^2$ und $R^3$ können auch miteinander zu einem nicht-aromatischen Ring verbunden sein können, $R^4$ für Wasserstoff oder eine Alkylgruppe steht, X für einen gegebenenfalls substituierten Benzoylrest oder ein gegebenenfalls substituiertes heteroaromatisches Ringsystem steht und n entweder 0, 1 oder 2 ist.

Als erfindungsgemäß im farbbildenden System der photopolymerisierbaren Aufzeichnungsmaterialien enthaltene Photooxidationmittel (b) kommen organische Salze der oben gekennzeichneten Art in Frage. Der Begriff "Salz" schließt dabei auch innere Salze ein, d.h. ionische Verbindungen, bei denen die kationischen und anionischen Gruppierungen durch kovalente Bindungen miteinander verknüpft sind. Als heteroaromatisches System in diesen Salzen, welches mindestens eine Gruppierung der oben angegebenen allgemeinen Formell (I) enthält, kommen insbesondere sechsgliedrige heteroaromatische Ringe mit 1, 2 oder auch 3 Ringstickstoffatomen, deren kernsubstituierte Derivate, einschließlich der benzanellierten und hetarylanellierten Vertreter in Betracht. Als Beispiele für die Kernsubstituenten dieser heteroaromatischen Systeme seien genannt: Alkyl-Gruppen, insbesondere mit 1 bis 6 C-Atomen, wie z.B. Methyl, Ethyl, Propyl und n-Butyl, substituierte Alkyl-Gruppen, wie z.B. halogensubstituierte Alkyl-Reste mit 1 bis 6 C-Atomen, Aralkyl-Reste, insbesondere der Benzylrest, durch anionische Gruppierungen substituierte Alkylreste, wie z.B. Alkylidensulfonat-Reste, die OH-Gruppe, der Amid- und Carboxyl-Rest, der Vinyl- oder Styryl-Rest, Phenyl, substituiertes Phenyl, Halogenatome, vorzugsweise Chloratom, die Nitro-Gruppe, ein Alkoxy-Rest, vorzugsweise mit 1 bis 6 C-Atomen, wie etwa Methoxy, der Formyl-Rest, Dialkylamino-, Diarylamino-, Alkylthiosowie der Arylthio-Rest und andere. Beispiele für den Rest R in der Gruppierung der oben angegebenen allgemeinen Formel (I) sind u.a. gegebenenfalls substituierter Cycloalkylrest, wie z.B. Cyclohexyl- oder 2-Hydroxycyclohexylrest, Aralkyl-Reste, insbesondere der Benzyl-Rest oder auch anionische Gruppierungen enthaltende Alkylreste, wie z.B. Alkylidensulfonat-Reste, der Phenyl-, Aryl- und Hetarylrest (ein N- und/oder S-haltiger fünf- oder sechsgliedriger heterocyclischer Ring). Weitere Beispiele für den Rest R in der allgemeinen Formel (I) sind der Alkoxycarbonyl-(Formel IV), der N-Carbamoyl-(Formel V), der N-Alkylsulfonyl-(Formel VI), der Arylsulfonylaminosulfinyl- (Formel VII) und das Pyridiniumkation nach Formel (VIII).

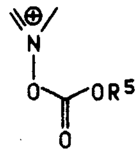

(IV)

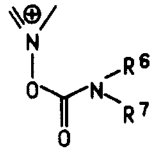

(V)

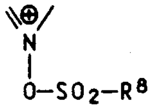

(VI)

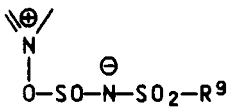

(VII)

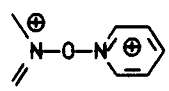

(VIII)

Darin bedeuten beispielsweise:

- $R^5$ geradkettige oder verzweigte Alkylgruppen, vorzugsweise mit 1 bis 6 Kohlenstoffatomen, wie z.B. Methyl, Ethyl, Propyl, insbesondere i-Butyl, substituierte Alkylgruppen, wie z.B. halogensubstituierte Alkylgruppen, insbesondere der 1,1,1-Trichlorethyl-Rest.
- $R^6$, $R^7$ können gleich oder verschieden sein und geradkettige oder verzweigte Alkylgruppen, wie z.B. Methyl, Ethyl, i-Propyl, n-Butyl sein. $R^6$ und $R^7$ können auch über $CH_2$-Gruppen miteinander verbunden sein, wobei auch eine $CH_2$-Einheit durch Heteroatome, wie z.B. substituierten Stickstoff oder Sauerstoff ersetzt sein kann. Insbesondere würden $R^6$ und $R^7$ dann für $(CH_2)_2$-O-$(CH_2)_2$ stehen.
- $R^8$ Alkyl- und halogensubstituierten Alkylrest, wie z.B. Trifluormethyl-Rest.
- $R^9$ Phenyl-, Aryl- und Alkyl-, Halogen-substituierter Aryl-Rest.

Es ist auch möglich, über die Kernsubstituenten der heteroaromatischen Systeme bzw. den Rest R in der Gruppierung der oben angegebenen allgemeinen Formel (I) zwei heteroaromatische, die Gruppierung der allgemeinen Formel (I) enthaltenden Systeme miteinander zu verbinden. Die erfindungsgemäß als Photooxidationsmittel (b) einzusetzenden Salze können als innere Salze vorliegen oder als Anionen die Anionen anorganischer und organischer Säuren enthalten, wie z.B. Chlorid, Bromid, Iodid, Hydrogensulfat, Fluorsulfonat, Perchlorat, Tetrafluorborat, Hexafluorophosphat, Hexachloroantimonat, Hexafluoroarsenat, Alkylsulfonate, Trifluormethansulfonat, Methylsulfat, Methylsulfit, Benzolsulfonat, substituierte Benzolsulfonate, wie z.B. p-Toluolsulfonat.

Durch geeignete Auswahl der Kernsubstituenten in dem heteroaromatischen System und/oder des Rests R in der Gruppierung der allgemeinen Formel (I) lassen sich die Aktivität bei Bestrahlung mit aktinischem Licht, sowie die thermische und chemische Stabilität der erfindungsgemäß einzusetzenden Photooxidationsmittel (b) beeinflussen und variieren. Darüber hinaus haben auch die Anionen in den erfindungsgemäß einzusetzenden Photooxidationsmitteln (b) einen Einfluß auf die Eigenschaften der photopolymerisierbaren Aufzeichnungsmaterialien. Üblicher- und vorteilhafterweise wird das Photooxidationsmittel (b) so ausgewählt, daß dessen molarer Extinktionskoeffizient $\epsilon$ im Wellenlängenbereich von 300 bis 420 nm, insbesondere im Bereich von 320 bis 400 nm, kleiner ist als der des in den erfindungsgemäßen photopolymerisierbaren Aufzeichnungsmaterialien mitverwendeten Sensibilisators für das Photooxidationsmittel (b) sowie gegebenenfalls den Photopolymerisationsinitiator.

Zu den erfindungsgemäß als Photooxidationsmittel (b) einzusetzenden Salzen gehören insbesondere die Pyridinium-, Pyrazinium- und Pyrimidinium-Salze, die im heteroaromatischen Ring eine Gruppierung der oben angegebenen allgemeinen Formel (I) eingebaut enthalten, ferner die kernsubstituierten Derivate dieser

Salze, die einen oder mehrere Kernsubstituenten der oben angegebenen Art im heteroaromatischen Ring enthalten, sowie auch anellierte Derivate dieser Salze, wie z.B. benzanellierte Pyridinium-Salze der in Rede stehenden Art, wie etwa die entsprechenden, gegebenenfalls kernsubstituierten Chinolinium-, Isochinolinium- oder Phenantridinium-Salze. Bevorzugt für den Rest R in der Gruppierung der allgemeinen Formel (I) sind dabei insbesondere der Alkenylcarbonyl-, Alkinylcarbonyl-, Alkoxycarbonyl-, Carbamoyl-, Alkylsulfonyl- und der Arylsulfonylaminosulfinyl-Rest. Zu den bevorzugten Kernsubstituenten für diese Salze gehören insbesondere die, gegebenenfalls substituierten, Alkyl-Reste. Als Anionen für diese Salze sind u.a. bevorzugt Chlorid-, Perchlorat-, Benzolsulfonat, Tosylat-, Alkylsulfonat-, Trifluormethansulfonat-, Tetrafluoroborat.

Zu den erfindungsgemäß als Photooxidationsmittel (b) einzusetzenden Salzen gehören beispielsweise Verbindungen der nachstehend angegebenen allgemeinen Formeln (II), (IX) bis (XVII)

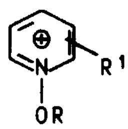 $A^{\ominus}$ (II)

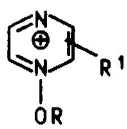 $A^{\ominus}$ (IX)

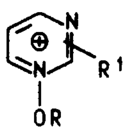 $A^{\ominus}$ (X)

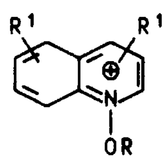 $A^{\ominus}$ (XI)

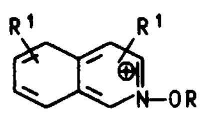 $A^{\ominus}$ (XII)

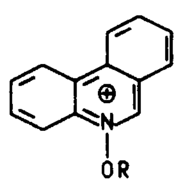 $A^{\ominus}$ (XIII)

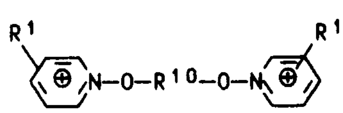 $2A^{\ominus}$ (XIV)

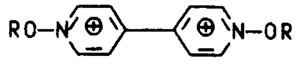 $2A^{\ominus}$ (XV)

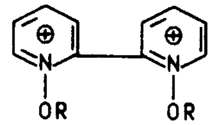 $2A^{\ominus}$ (XVI)

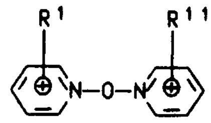 $2A^{\ominus}$ (XVII)

In den Formeln (II), (IX) bis (XVI) hat der Rest R die weiter oben bei der allgemeinen Formel (I) angegebene Bedeutung, wobei in den Verbindungen der allgemeinen Formeln (II), (IX) bis (XVI) R vorzugsweise einen substituierten Cyclohexylrest, wie z.B. 2-Hydroxycyclohexyl, einen Alkoxycarbonyl-Rest gemäß Formel (IV), mit $R^5$ bevorzugt 1,1,1-Trichlorethyl-, einen Carbamoyl-Rest nach Formel (V), wobei $R^6$ und $R^7$ bevorzugt gleich sind und Methyl, Ethyl, i-Propyl oder n-Butyl sein und $R^6$-N-$R^7$ auch für Morpholino stehen können. In den Formeln (II), (IX) bis (XVI) kann R weiterhin ein Alkylsulfonyl-Rest nach (VI) mit $R^8$ bevorzugt Trifluormethyl und eine Alkylsulfonylaminosulfinyl-Gruppe gemäß Formel (VII) sein.

Der Rest $R^1$ steht in diesen Formeln für ein Wasserstoffatom (entsprechend einem unsubstituierten heteroaromatischen Ring) oder einen oder mehrere Kernsubstituenten der vorstehend angegebenen Art, vorzugsweise für Wasserstoff oder eine oder mehrere, gegebenenfalls substituierte, Alkyl-, Aryl-, Dialkylamino-, Diarylamino-, Alkylthio-, Arylthio-, Alkoxygruppen oder Chloratom. Insbesondere stellt $R^1$ ein Wasserstoffatom oder eine oder mehrere Methylgruppen, vorzugsweise 2-Methyl, 2,6-Dimethyl, oder in den allgemeinen Formeln (II), (IX) und (XVI), auch 3,5-Dimethyl dar. In Formel (XIV) steht $R^{10}$ für einen Alkyliden-Rest, insbesondere mit 2 bis 6 C-Atomen, oder einen Xylylen-Rest, z.B. den p-Xylylen-Rest. In Formel (XVII) ist $R^{11}$ bevorzugt ein Wasserstoffatom. Ferner steht in den Formeln (II) und (IX) bis (XVII) $A^{\ominus}$ für ein Säureanion, insbesondere der weiter oben angegebenen Art. Bevorzugte Säureanionen für die Verbindungen der allgemeinen Formeln (II) und (IX) bis (XVII) sind das Benzolsulfonat-, Toluolsulfonat-, Methylsulfonat-, n-Octylsulfonat-, Tetrafluoroborat-, Hexafluorphosphat- und Trifluormethansulfonat-Anion. Für den Fall, daß einer der Reste R oder $R^1$ eine Anionen-Gruppierung, z.B. eine Sulfonat-Gruppe, enthält, entfällt selbstverständlich das Anion $A^{\ominus}$ in den allgemeinen Formeln (II) und (IX) bis (XVII).

Unter den erfindungsgemäß als Photooxidationsmittel (b) einzusetzenden Salzen kommt den Verbindungen der allgemeinen Formel (II) besondere Bedeutung zu, wobei sich hier speziell die Verbindungen als besonders vorteilhaft erwiesen haben, in denen der Rest $R^1$ ein Wasserstoffatom oder eine bzw. zwei Methyl-Gruppen darstellt.

Als Beispiele für Verbindungen, die erfindungsgemäß als Photooxidationsmittel (b) in den photopolymerisierbaren Aufzeichnungsmaterialien eingesetzt werden können, seien genannt: 1-(Acryloyloxy)-pyridiniumchlorid, 1-(Methacryloyloxy)-pyridiniumchlorid, 1-(Isobutoxycarbonyloxy)-pyridiniumchlorid, 1-(Isobutoxycarbonyloxy)-2-picoliniumchlorid, 1-(Isobutoxycarbonyloxy)-3-picoliniumchlorid, 1-(Isobutoxycarbonyloxy)-4-picoliniumchlorid, 1-(Isobutoxycarbonyloxy)-2,6-dimethylpyridiniumchlorid, 1-($\alpha,\alpha,\alpha$-Trichlorethoxycarbonyloxy)-pyridiniumchlorid, 1-(N,N-Dimethylcarbamoyloxy)-pyridiniumchlorid, 1-(N-Morpholinocarbonyloxy)-pyridiniumchlorid, 1-(N-Morpholinocarbonyloxy)-pyridiniumtetrafluoroborat, 1-(N-Morpholinocarbonyloxy)-pyridiniumhexafluorophosphat, 1-(N-Morpholinocarbonyloxy)-2,6-dimethylpyridiniumchlorid, 1-(N-Morpholinocarbonyloxy)-3,5-dimethylpyridiniumchlorid, 1-(Trifluormethylsulfonyloxy)-pyridiniumtrifluormethansulfonat, 1-(Benzolsulfonylaminosulfinyloxy)-pyridiniumbetain, 1-(N-Pyridiniumoxy)-pyridiniumbistrifluormethansulfonat.

Die erfindungsgemäß als Photooxidationsmittel (b) einzusetzenden Salze der vorstehend beschriebenen Art lassen sich nach üblichen und gängigen, literaturbekannten Verfahren oder in Analogie zu diesen herstellen. Verwiesen sei in diesem Zusammenhang z.B. auf R.A. Abramovitch und E.M. Smith in "Pyridine and its Derivatives", Vol. 14 Supplement, Part 2, J. Wiley, New York (1974).

Das in den photopolymerisierbaren Aufzeichnungsmaterialien der Erfindung enthaltene farbbildende System, welches bei Bestrahlung der Aufzeichnungsmaterialien mit aktinischem Licht eine Zunahme der Farbintensität in diesen Materialien bewirkt, enthält neben dem Photooxodationsmittel (b) der vorstehend beschriebenen Art mindestens eine farblose oder praktisch farblose organische Verbindung (a), die zu einer farbigen Verbindung oxidierbar ist. Diese farbbildende, zunächst farblose oder praktisch farblose organische

Verbindung (a) wird im folgenden auch als Farbbildner bezeichnet. Als Farbbildner (a) kommen insbesondere Leukofarbstoffe in Betracht, wobei unter Leukofarbstoff die reduzierte Form eines Farbstoffes verstanden wird, die im allgemeinen 1 bis 2 Wasserstoffatome aufweist, deren Entfernung gemeinsam mit einem oder zwei Elektronen zur Erzeugung des Farbstoffes führt. Diese Leukofarbstoffe sind im wesentlichen farblos oder weisen allenfalls eine geringe, wenig intensive Färbung auf, die von der Farbe des eigentlichen Farbstoffs (oxidierte Form) deutlich verschieden ist. Geeignete Leukofarbstoffe sind insbesondere die Diarylmethan- und Triarylmethan-Farbstoffe in ihrer Leukoform bzw. Farbstoffe mit einer Triarylmethangrundstruktur, bei denen zwei der Arylreste über ein N-, S- oder O-Atom miteinander verknüpft sind, in ihrer Leukoform. Hierzu gehören u.a. die Leukoformen der Aminoacridin-Farbstoffe, der Aminoxanthen-Farbstoffe und der Aminothioxanthen-Farbstoffe. Geeignet sind ebenfalls Leukofarbstoffe des Triarylmethan-Typs, bei denen ein Dialkyl- bzw. Alkyl-aryl-aminophenyl-Rest durch eine N-Alkyl-substituierte Carbazolyl-Gruppe ersetzt ist, wie sie beispielsweise in der US-A-4 154 463 beschrieben sind. Ferner können als Farbbildner (a) beispielsweise auch Leukomethine eingesetzt werden. Leukofarbstoffe, die als Farbbildner (a) für die erfindungsgemäßen photopolymerisierbaren Aufzeichnungsmaterialien geeignet sind, sind beispielsweise in der US-A-3 552 973 beschrieben. Von besonderem Interesse sind dabei die Leukotriarylmethanfarbstoffe, wie z.B. Leukokristallviolett, Leukomalachitgrün, Leukobasischblau, Leukopararosanilin, Leukopatentblau A oder V.

Das Verhältnis von Farbbildner (a) und Photooxidationsmittel (b) in den photopolymerisierbaren Aufzeichnungsmaterialien ist so zu wählen, daß auf alle Fälle ein hinreichender Farbumschlag bei Belichtung mit aktinischem Licht bewirkt wird. Üblicherweise hat es sich als sinnvoll herausgestellt, das Photooxidationsmittel (b) in einem geringen Überschuß (gewichtsmäßig) im Vergleich zum Farbbildner (a) einzusetzen. Im übrigen werden Mengen und Mengenverhältnisse von Farbbildner (a) und Photooxidationsmittel (b) in der für den Fachmann üblichen und bekannten Weise so ausgewählt, daß die photopolymerisierbaren Aufzeichnungsmaterialien die an sie gestellten Anforderungen bezüglich Belichtungszeit, Farbkontrast etc. erfüllen.

Neben einem farbbildenden System der vorstehend beschriebenen Art enthalten die erfindungsgemäßen photopolymerisierbaren Aufzeichnungsmaterialien mindestens eine photopolymerisierbare, olefinisch ungesättigte organische Verbindung, gegebenenfalls ein polymeres Bindemittel, mindestens einen Photopolymerisationsinitiator, mindestens einen Sensibilisator sowie gegebenenfalls weitere Zusatz- und/oder Hilfsstoffe. Für diese weiteren Bestandteile der erfindungsgemäßen photopolymerisierbaren Aufzeichnungsmaterialien kommen die Verbindungen in Betracht, wie sie für die an sich bekannten photopolymerisierbaren Massen, die für die Herstellung von Überzügen, Druckplatten, Photoresistmaterialien und ähnlichen Zwekken eingesetzt werden, verwendet werden und beispielsweise in der eingangs zitierten Literatur beschrieben sind.

Bei den photopolymerisierbaren, olefinisch ungesättigten organischen Verbindungen kann es sich um olefinisch ungesättigte Monomere, olefinisch ungesättigte Oligomere und/oder Polymere mit photopolymerisierbaren, olefinischen Doppelbindungen handeln. Die photopolymerisierbaren, olefinisch ungesättigten organischen Verbindungen enthalten vorzugsweise vinylische Doppelbindungen und insbesondere Vinyl-Gruppen, die durch Konjugation und/oder Nachbarschaftsstellung zu O- oder N-Atomen aktiviert sind. Hierzu gehören insbesondere die Vinyl-Gruppen in Nachbarschaft zu Ester- oder Amidgruppen, wie z.B. die Acryloyl- und Methacryloyl-Gruppierungen. Die photopolymerisierbaren, olefinisch ungesättigten organischen Verbindungen können sowohl mono- als auch polyfunktionell sein, d.h. sie können eine oder auch mehrere der photopolymerisierbaren olefinischen Doppelbindungen besitzen. Üblicherweise sind in den photopolymerisierbaren Aufzeichnungsmaterialien bi- oder mehrfunktionelle olefinisch ungesättigte, photopolymerisierbare Verbindungen allein oder in Mischung hiervon mit monofunktionellen olefinisch ungesättigten photopolymerisierbaren organischen Verbindungen enthalten. Die photopolymerisierbaren olefinisch ungesättigten Monomeren haben im allgemeinen ein Molekulargewicht von bis zu etwa 1 000. Das mittlere Molekulargewicht (Zahlenmittel) der photopolymerisierbaren olefinisch ungesättigten Oligomeren liegt vorzugsweise im Bereich von etwa 1 000 bis 10 000, insbesondere von etwa 1 500 bis 6 000. Das Molekulargewicht (Gewichtsmittel) der photopolymerisierbare, olefinische Doppelbindungen enthaltenden Polymeren liegt im allgemeinen über 15 000. Die photopolymerisierbaren, olefinisch ungesättigten organischen Verbindungen können allein oder auch in Mischung miteinander eingesetzt werden. Art und Menge der verwendeten photopolymerisierbaren, olefinisch ungesättigten organischen Verbindungen richten sich weitgehend nach dem Anwendungszweck der photopolymerisierbaren Aufzeichnungsmaterialien sowie nach der Art der weiteren mitverwendeten Bestandteile.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem

Molekulargewicht bis etwa 500, 1,2-Propandiol, 1,3-Propandiol, Polypropylenglykolen mit einem Molekulargewicht bis etwa 500, 1,4-Butandiol, 1,6-Hexandiol, 1,1,1-Trimethylolpropan, 2,2-Dimethylpropandiol, Glycerin oder Pentaerythrit; Pentaerythrittetra-(meth)acrylat, Glukosetri- oder tetra-(meth)acrylat; ferner die Monoacrylate und Monomethacrylate der genannten Diole und Polyole, wie z.B. Ethylenglykol-, Di-, Tri- oder Tetraethylenglykol-mono-(meth)acrylat, Propandiolmono-(meth)acrylat und Butandiol-mono-(meth)acrylat; sowie die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acryl-amid, N-Methylol-(meth)acrylamid, der Bisether des Ethylenglykols und N-Methylol-(meth)acrylamids, Vinylcarbamate, Bisacrylamidoessigsäure, Glyoxalbisamid u.a.

Sehr geeignete photopolymerisierbare, olefinisch ungesättigte organische Verbindungen für die erfindungsgemäßen, photopolymerisierbaren Aufzeichnungsmaterialien sind auch die monomeren Urethanacrylate bzw. -methacrylate mit 2 oder mehr Acryloyl- und/oder Methacryloyl-Gruppen. Solche monomeren Urethan-(meth)acrylate können beispielsweise erhalten werden durch die Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- und/oder Polyole kommen u.a. die vorstehend im Zusammenhang mit den Di- und Tri-(meth)-acrylaten genannten Di- und Polyhydroxy-Verbindungen in Betracht. Als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl(meth)acrylat, Propandiol-mono-(meth)acrylat oder Butandiol-mono-(meth)acrylat. Ebenso geeignet und vorteilhaft sind Monomere mit 2 oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure bzw. durch Umsetzung von Glycidyl-(meth)acrylat mit Di- oder Polyolen, insbesondere aliphatischen Di- oder Polyolen, wie sie beispielsweise vorstehend im Zusammenhang mit den Di- und Tri(meth)acrylaten genannt sind. Als Di- und Polyglycidylverbindungen kommen hier insbesondere die Di- und Polyglycidylether mehrwertiger aliphatischer Alkohole oder mehrwertiger Phenole, beispielsweise des Bisphenols A oder der Substitutionsprodukte von Bisphenol A in Betracht. Beispielhaft für solche Acryloyl- und/oder Methacryloyl-Gruppen enthaltenden Monomeren seien die Umsetzungsprodukte des Bisphenol A-bis-glycidylethers mit Acryl- und/oder Methacrylsäure im molaren Verhältnis von etwa 1:2 sowie das 1,6-Hexandiol-bis-glycidylether-bis-methacrylat genannt.

Als vorteilhaft, insbesondere für die Herstellung von Photoresistschichten, hat es sich erwiesen, wenn die photopolymerisierbaren Aufzeichnungsmaterialien als photopolymerisierbare, olefinisch ungesättigte organische Verbindung Oligomere mit 2 oder vorzugsweise mehr als zwei Acryloyl-und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind. Für wäßrig entwickelbare photopolymerisierbare Aufzeichnungsmaterialien sind hierbei solche Oligomeren der in Rede stehenden Art von besonderem Interesse, die neben den Acryloyl- und/oder Methacryloyl-Gruppen zusätzlich noch freie Carboxylgruppen im Molekül enthalten. Der Anteil der freien Carboxylgruppen in diesen photopolymerisierbaren Oligomeren liegt dabei vorteilhafterweise so hoch, daß die Oligomeren eine Säurezahl im Bereich von 50 bis 150 mg KOH/g aufweisen. Geeignete photopolymerisierbare Oligomere dieser Art sind z.B. in der DE-A-24 42 527, der DE-C-25 57 408 oder auch der DE-A-29 17 483 beschrieben. Weitere photopolymerisierbare Oligomere, deren Einsatz in den erfindungsgemäßen photopolymerisierbaren Aufzeichnungsmaterialien sich als vorteilhaft herausgestellt hat, können beispielsweise hergestellt werden, indem man die freien Hydroxylgruppen einer Acryloyl- und/oder Methacryloyl-Gruppen enthaltenden Diol- oder Polyolverbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsproduktes unter Kettenverlängerung sowie gegebenenfalls Verzweigung mit Di-und/oder Polyepoxiden umsetzt. Die Acryloyl- und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di- oder Polyglycidylether bzw. Di- oder Polyglycidylester, mit Acrylsäure und/oder Methacrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für solche Oligomeren

der letztgenannten Art seien die Produkte genannt, wie sie erhältlich sind durch Umsetzung von Bisphenol A-bisglycidylether mit Acryl- und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von 1:1 unter Bildung der sauren Teilester der mehrfachen Carbonsäuren und schließlich Umsetzung eines Teils der freien Carboxyl-Gruppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen:Glycidylgruppen von > 1:1, vorzugsweise im Bereich von etwa 1,15:1 bis 5:1.

Als photopolymerisierbare olefinische Doppelbindungen enthaltende Polymere kommen beispielsweise solche lichtempfindlichen Polymeren in Betracht, wie sie z.B. in der DE-A-15 22 359 beschrieben sind.

Die photopolymerisierbaren, olefinisch ungesättigten organischen Verbindungen, die üblicherweise einen Siedepunkt von über 100 °C bei Atmosphärendruck aufweisen, sind dabei - für den Fachmann selbstverständlich - so zu wählen, daß sie mit den übrigen Bestandteilen der photopolymerisierbaren Aufzeichnungsmaterialien, insbesondere gegebenenfalls mitverwendeten polymeren Bindemitteln, verträglich sind.

Die bevorzugten photopolymerisierbaren Aufzeichnungsmaterialien enthalten neben den photopolymerisierbaren, olefinisch ungesättigten organischen Verbindungen polymere Bindemittel, insbesondere dann, wenn als photopolymerisierbare olefinisch ungesättigte organische Verbindungen ausschließlich photopolymerisierbare Monomere und/oder photopolymerisierbare Oligomere enthalten sind. Die polymeren Bindemittel sollen dabei in den Entwicklerlösungsmitteln für die photopolymerisierbaren Aufzeichnungsmaterialien löslich oder zumindest dispergierbar sein, um ein Auswaschen der unbelichteten und unvernetzten Anteile einer Schicht aus diesen Materialien nach einer bildmäßigen Belichtung mit aktinischem Licht zu ermöglichen. Als geeignete polymere Bindemittel seien genannt: lineare Polyamide und besonders alkohollösliche Copolyamide, wie sie in der FR-PS 1 520 856 beschrieben sind, Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, des Vinylchlorids oder des Styrols, Polyurethane, Polyetherurethane, Polyesterurethane, Polyesterharze, Dien-Polymere und -Copolymere, wie Blockcopolymerisate aus Butadien und/oder Isopren und Styrol oder α-Methylstyrol, sowie, insbesondere für die Herstellung von Photoresistschichten und Flachdruckplatten, auch die Acrylsäurealkylester- und Methacrylsäurealkylester-Polymerisate und -Copolymerisate. Beispiele für geeignete und bevorzugte polymere Bindemittel sind u.a. Polymethacrylat, Polymethylmethacrylat, Alkyl-(meth)acrylat-Copolymerisate, die Amino-Gruppen enthaltende Comonomere, wie z.B. Dimethylaminoethylmethacrylat, einpolymerisiert enthalten, Copolymerisate von Alkyl(meth)acrylaten und (Meth)acrylsäure, die gegebenenfalls noch weitere Comonomere, wie z.B. N-Vinyllactame, Hydroxyalkyl(meth)acrylate oder Styrol, einpolymerisiert enthalten, Copolymerisate aus Styrol und Maleinsäureanhydrid und/oder Maleinsäurehalbester oder auch Copolymerisate von Styrol, Maleinsäureanhydrid und (Meth)acrylsäure.

Die erfindungsgemäßen photopolymerisierbaren Aufzeichnungsmaterialien enthalten ferner - zusätzlich zu dem Photooxidationsmittel (b) des farbbildenden Systems - als weitere lichtempfindliche Komponente mindestens einen Photopolymerisationsinitiator, der unter Einwirkung von aktinischem Licht die radikalische Polymerisation der photopolymerisierbaren olefinisch ungesättigten organischen Verbindungen in dem photopolymerisierbaren Aufzeichnungsmaterial zu initiieren vermag. Als besonders vorteilhaft haben sich hier die als Photoinitiator bekannten aromatischen Carbonylverbindungen erwiesen, insbesondere aromatische Ketone, die eine Struktureinheit der allgemeinen Formel (XVIII)

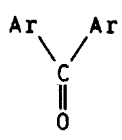

(XVIII)

aufweisen, worin Ar für einen gegebenenfalls substituierten Arylrest, insbesondere einen gegebenenfalls substituierten Phenylrest, steht. Die beiden Reste Ar in der Struktureinheit der allgemeinen Formel (XIII) können dabei gleich oder verschieden sein sowie gegebenenfalls auch, beispielsweise über eine -CH-Gruppe oder ein -S-Atom, miteinander verknüpft sein. Bevorzugt werden die Photopolymerisationsinitiatoren

so ausgewählt, daß sie keine starke Absorption ($\epsilon$ < 5000) in dem Wellenlängenbereich des aktinischen Lichts haben, in dem die in den erfindungsgemäßen photopolymerisierbaren Aufzeichnungsmaterialien enthaltenen Sensibilisatoren ihre Absorptionsbande(n) haben. Als Beispiele für bevorzugte Photopolymerisationsinitiatoren seien genannt Benzophenon, substituierte Benzophenone, wie 4,4′-Dichlorbenzophenon, mehrkernige unsubstituierte oder substituierte Chinone, wie Anthrachinon, Benzanthrachinon, 2-Ethylanthrachinon oder tert.-Butylanthrachinon, sowie Thioxanthone, wie z.B. 2-Methyl-, 2-Isopropyl- oder 2-Chlorthioxanthon.

Die erfindungsgemäßen photopolymerisierbaren Aufzeichnungsmaterialien enthalten darüber hinaus mindestens einen Sensibilisator im weiteren Sinne, d.h. eine Verbindung, die bei Bestrahlung der photopolymerisierbaren Aufzeichnungsmaterialien mit aktinischem Licht das Photooxidationsmittel (b) und/oder den Photopolymerisationsinitiator aktiviert. Als Sensibilisatoren für die erfindungsgemäßen photopolymerisierbaren Aufzeichnungsmaterialien kommen insbesondere elektronenreiche aromatische Verbindungen in Betracht. Vorzugsweise werden als Sensibilisatoren tertiäre aromatische Amine eingesetzt, insbesondere solche, in denen der Aminophenylrest mit einem Carbonylrest, insbesondere einem aromatischen Carbonylrest so verbunden ist, daß die Doppelbindungen miteinander in Konjugation stehen. Hierzu gehören beispielsweise aromatische Amine der allgemeinen Formel (III)

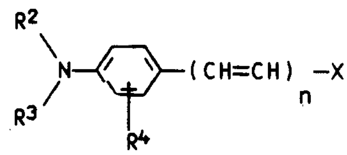

(III)

worin $R^2$ und $R^3$ gleich oder verschieden sein können und stehen für eine gegebenenfalls substituierte Alkylgruppe mit 1 bis 6 Kohlenstoffatomen, eine Phenylgruppe oder eine Aralkylgruppe, $R^2$ und $R^3$ auch miteinander zu einem nicht-aromatischen Ring verbunden sein können, $R^4$ vorzugsweise für Wasserstoff oder eine Alkylgruppe steht, n entweder 0, 1 oder 2 ist und X für einen gegebenenfalls substituierten Benzoylrest oder ein gegebenenfalls substituiertes, heteroaromatisches Ringsystem, wie beispielsweise einen gegebenenfalls substituierten und/oder benzanellierten Pyridin-, Diazol-, Triazol-, Thiazol-, Oxazol-, Thiadiazol- oder Oxdiazol-Ring steht. Als Beispiele für den Rest X in den Sensibilisatoren der allgemeinen Formel (III) seien die folgenden Reste angeführt:

(1) 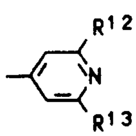

mit $R^{12}$, $R^{13}$ (gleich oder verschieden und unabhängig voneinander) = H, Alkyl mit 1 bis 6 C-Atomen oder ggf. durch Halogenatom, Alkyl oder Alkoxy substituiertes Aryl,

(2) 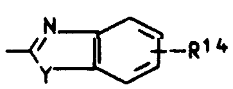

mit Y = O, S, Se oder $NR^{15}$ (mit $R^{15}$:H, Alkyl oder Phenyl und $R^{14}$ = H, Alkyl, Alkoxy oder Phenyl,

(3) 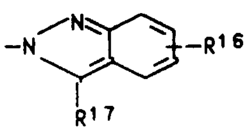

mit $R^{16}$ = H oder Cl und $R^{17}$ = H, $NH_2$ oder Dialkylamino,

(4) 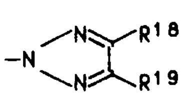

mit $R^{18}$, $R^{19}$ (gleich oder verschieden unabhängig voneinander) = Alkyl, Alkenyl, Carbalkoxy, ggf. durch Halogenatom, Alkyl oder Alkoxy substituiertes Phenyl oder $R^{18}$ und $R^{19}$ zusammen einen gesättigten 5- oder 6-Ring bildend

(5) 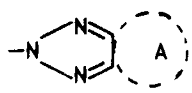

mit A = dem Rest zur Ergänzung eines aromatisch ungesättigten, carbocyclischen oder heterocyclischen Ringsystems, wie z.B. Benzol, Naphthalin oder Pyrazol, wobei das durch A gebildete Ringsystem ggf. durch Halogenatom, Alkyl oder Alkoxy substituiert sein kann,

(6) 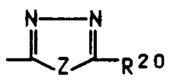

mit Z = O, S oder $NR^{21}$ (mit $R^{21}$ = H, Alkyl oder Phenyl) und $R^{20}$ = H, Alkyl, ggf. durch Alkyl, Alkoxy oder Dialkylamino substituiertes Phenyl, Naphthyl oder Biphenyl,

(7) 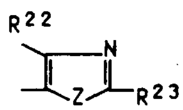

mit Z = O, S oder $NR^{24}$ (mit $R^{24}$ = H, Alkyl oder Phenyl), $R^{22}$ = H, Alkyl oder ggf. substituiertes Phenyl und $R^{23}$ = H, Alkyl, ggf. durch Alkyl, Alkoxy oder Dialkylamino substituiertes Phenyl, Naphthyl, Biphenyl oder Vinyl,

(8) 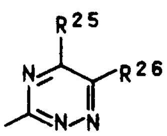

mit $R^{25}$, $R^{26}$ = 5- oder 6-gliedrigen aromatischen oder heteroaromatischen Ringsystemen, die durch Alkyl oder Alkoxy-Reste substituiert sein können.

Bevorzugte Sensibilisatoren für die erfindungsgemäßen photopolymerisierbaren Aufzeichnungsmaterialien sind solche der allgemeinen Formel (III), worin X eine der folgenden Bedeutungen hat (n = 0):

(9) 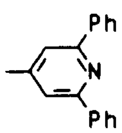

(10) 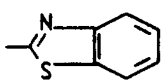

(11) 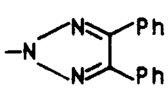

(12) 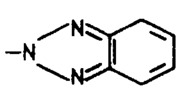

(13) 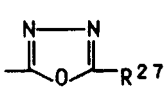

mit $R^{27}$ = einen durch Dialkylamino substituierten Phenylrest

Als Beispiele für geeignete und bevorzugte Sensibilisatoren seien u.a. 2,5-Bis-(4′-diethylaminophenyl)-1,3,4-oxdiazol, 2-(4′-Diethylaminophenyl)-1,2,3-benztriazol, 2-(4′-Diethylaminophenyl)-4,5-diphenyl-1,2,3-triazol, 2-(4-Dimethylaminophenyl)-benzthiazol, 2-(4-Dimethylaminophenyl)-benzoxazol, 2-(4-Dimethylaminostyryl)-benzthiazol und 2-(4-Diethylaminostyryl)-naphtho(1,2d)thiazol genannt.

X steht weiterhin auch für einen, vorzugsweise substituierten, Benzoylrest des Typs

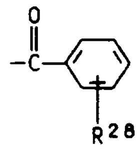

mit $R^{28}$ = H, Alkyl, Cycloalkyl, Hydroxyalkyl, Hydroxy, Cl, Br, Alkoxy, Alkylthio, Dialkylamino oder Diarylamino, vorzugsweise in p-Stellung. Bevorzugte Verbindungen sind solche, bei denen der Benzoylrest die Bedeutung

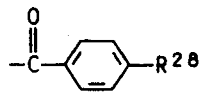

hat mit $R^{28}$ = Dialkylamino oder Diarylamino. Als bevorzugte Sensibilisatoren dieser Kategorie seien u.a. 4-Dimethylaminobenzophenon, 4,4′-Bis(dimethylamino)-benzophenon, 4,4′-Bis(diethylamino)-benzophenon und 4,4′-Bis(hydroxyethylmethylamino)-benzophenon genannt.

Das farbbildende System mit den erfindungsgemäß einzusetzenden Photooxidationsmitteln (b) bewirkt dabei überraschenderweise in den erfindungsgemäßen photopolymerisierbaren Aufzeichnungsmaterialien mit den Sensibilisatoren der vorstehend beschriebenen Art eine sehr starke Erhöhung der Farbintensität und Kontrastbildung schon bei den relativ kurzen Belichtungszeiten mit aktinischem Licht, wie sie für die photopolymerisierbaren Aufzeichnungsmaterialien gefordert werden.

Neben den genannten Bestandteilen können die erfindungsgemäßen photopolymerisierbaren Aufzeichnungsmaterialien noch weitere, übliche, die verarbeitungs- und/oder anwendungstechnischen Eigenschaften der Aufzeichnungsmaterialien verbessernde und/oder modifizierende Zusatz- und/oder Hilfsstoffe enthalten. Hierzu gehören u.a. thermische Polymerisationsinhibitoren, anorganische oder organische Pigmente oder Farbstoffe, die sowohl als Kontrastmittel als auch schichtverfestigend wirken können, niedermolekulare Haftvermittler, Verlaufshilfsmittel, Mattierungs- oder Gleitmittel, Weichmacher und dgl.

Die Bestandteile der erfindungsgemäßen photopolymerisierbaren Aufzeichnungsmaterialien werden in den für sie üblichen und an sich bekannten Mengen und Mengenverhältnissen eingesetzt und liegen in den Aufzeichnungsmaterialien in homogener Mischung vor. Zur Herstellung der photopolymerisierbaren Aufzeichnungsmaterialien werden die Bestandteile nach den an sich bekannten Verfahren homogen miteinander vermischt, beispielsweise in Lösung in einem geeigneten Lösungsmittel oder Lösungsmittelgemisch oder in einer Mischvorrichtung, wie einem Kneter, Extruder oder dgl. Vorzugsweise werden Art und Menge der einzelnen Bestandteile der erfindungsgemäßen photopolymerisierbaren Aufzeichnungsmaterialien so aufeinander abgestimmt, daß die resultierende Mischung - sofern die Mischung in Lösung hergestellt wurde, nach Entfernung des Lösungsmittels - fest ist.

Zum Auslösen der Photopolymerisation und der Farbbildung bzw. der Vertiefung der Farbintensität in den erfindungsgemäßen photopolymerisierbaren Aufzeichnungsmaterialien dient aktinisches Licht einer Wellenlänge von 300 bis 420 nm, insbesondere solches im Wellenlängenbereich von 320 bis 400 nm. Als Strahlungsquellen sind u.a. allgemein zugänglich Quecksilberhochdrucklampen, Quecksilbermitteldrucklampen, Quecksilberniederdrucklampen, superaktinische Leuchtstoffröhren, Xenon-Impulslampen, UV-Fluoreszenzröhren und dgl. geeignet.

Die erfindungsgemäßen Aufzeichnungsmaterialien können in an sich bekannter Weise zu UV-härtbaren Überzügen, Photopolymerdruckplatten jeder Art, Reliefformen, Photoresists und dgl. verarbeitet werden. Besonders vorteilhaft sind sie dort, wo bei der Bestrahlung mit aktinischem Licht neben einer guten Photopolymerisation in den belichteten Bereichen auch eine möglichst große Änderung der Farbintensität und ein möglichst großer Farbkontrast gewünscht wird, wie beispielsweise in lichtempfindlichen Aufzeichnungselementen mit einer auf einem Trägermaterial aufgebrachten dünnen Schicht aus den erfindungsgemäßen photopolymerisierbaren Aufzeichnungsmaterialien, insbesondere Trockenfilmresists für die trockene Schichtübertragung und Flachdruckplatten. Als Trägermaterialien für diese lichtempfindlichen Aufzeichnungselemente kommen die hierfür üblichen dimensionsstabilen, vorzugsweise biegsamen, Materialien, wie Kunststofffilme oder -folien und Metallbleche, in Betracht. Für Trockenfilmresists haben sich als Träger insbesondere Polyesterfolien, beispielsweise aus Polyethylenterephthalat oder Polybutylenterephthalat, bewährt. Für Flachdruckplatten finden als Trägermaterialien insbesondere die offsettypischen Aluminiumbleche Anwendung, deren Oberfläche in an sich bekannter Weise mechanisch, chemisch und/oder elektrochemisch aufgerauht und vorbehandelt ist. Die dünne Schicht aus den erfindungsgemäßen photopolymerisierbaren Aufzeichnungsmaterialien, die für Trockenfilmresists üblicherweise im Bereich von etwa 10 bis 100 µm, insbesondere im Bereich von etwa 15 bis 70 µm, und für Flachdruckplatten üblicherweise im Bereich von etwa 1 bis 6 µm liegt, wird auf die Trägermaterialien nach bekannten Auftragstechniken, beispielsweise durch Gießen aus Lösung, spin coating oder dgl., aufgebracht.

Für die Herstellung von Flachdruckformen werden die mit den erfindungsgemäßen photopolymerisierbaren Aufzeichnungsmaterialien hergestellten Flachdruckplatten in üblicher Weise bildmäßig mit aktinischem Licht belichtet und durch Auswaschen mit einem geeigneten Entwicklerlösungsmittel entwickelt. Zur Herstellung von bildmäßig strukturierten Resistmustern wird das erfindungsgemäße photopolymerisierbare Aufzeichnungsmaterial schichtförmig auf das zu schützende, sowie gegebenenfalls dauerhaft zu modifizierende Substrat, entweder direkt, beispielsweise aus Lösung, oder durch Auflaminieren einer vorgefertigten Schicht nach dem Schichtübertragungsverfahren mittels eines Trockenfilmresists, aufgebracht. Als Substrat, dessen Art sich bekanntermaßen nach dem jeweiligen Anwendungszweck des herzustellenden Resistmusters richtet, kommen die in diesem Bereich üblichen und bekannten Materialien, wie z.B. Kupferbleche oder kupferkaschierte Basismaterialien in Betracht. Zur Erzeugung des bildmäßig strukturierten Resistmusters wird die auf das Substrat aufgebrachte Photoresistschicht aus den erfindungsgemäßen photopolymerisierbaren Aufzeichnungsmaterialien bildmäßig mit aktinischem Licht belichtet und anschließend unter Entfernen der unbelichteten Schichtbereiche mit einem geeigneten Entwicklerlösungsmittel ausgewaschen. Für die bildmäßige Belichtung der erfindungsgemäßen photopolymerisierbaren Aufzeichnungsmaterialien kommt aktinisches Licht in dem vorstehend genannten Wellenlängenbereich in Betracht. Die Art des Entwicklerlösungsmittels richtet sich nach den für den Aufbau der erfindungsgemäßen photopolymerisierbaren Aufzeichnungsmaterialien verwendeten Bestandteile, insbesondere dem eingesetzten polymeren Bindemittel und/oder den photopolymerisierbaren, olefinisch ungesättigten organischen Verbindungen. Danach können sowohl organische Lösungsmittel oder Lösungsmittelgemische wie auch wäßrige Entwicklerlösungen zur Anwendung kommen.

Das farbbildende System in den erfindungsgemäßen photopolymerisierbaren Aufzeichnungsmaterialien besitzt eine hohe Stabilität. Die photopolymerisierbaren Aufzeichnungsmaterialien weisen daher eine ausgezeichnete Dunkellagerfähigkeit auf, ohne daß es hierzu des Zusatzes großer Mengen eines thermischen Inhibitors bedarf, wie er bei den Produkten nach dem Stand der Technik erforderlich ist. Bei der Belichtung mit aktinischem Licht zeigen die erfindungsgemäßen photopolymerisierbaren Aufzeichnungsmaterialien,die in ihrem farbbildenden System die erfindungsgemäß einzusetzenden, leicht zugänglichen Photooxidationsmittel enthalten, eine unerwartet große Zunahme der Farbintensität und einen stärkeren Farbkontrast zwischen belichteten und unbelichteten Bereichen, als er bei vergleichbaren bekannten Produkten erzielt wird, die als Photooxidationsmittel beispielsweise eine organische Halogenverbindung enthalten. Dies war völlig überraschend, zumal die aus dem Stand der Technik bekannten photographischen Aufzeichnungsmaterialien mit einem ähnlichen farbbildenden System, die aber, im Vergleich zu den erfindungsgemäßen photopolymerisierbaren Aufzeichnungsmaterialien keine photopolymerisierbaren, organischen Verbindungen, Photoinitiatoren und Sensibilisatoren enthalten, bei vergleichbaren Belichtungszeiten nur eine relativ schwache Farbänderung zeigen. Die Verwendung der erfindungsgemäß einzusetzenden Photooxidationsmittel in den photopolymerisierbaren Aufzeichnungsmaterialien hat dabei keinen nachteiligen Einfluß auf die anderen, für die Herstellung und Verwendung dieser Aufzeichnungsmaterialien wichtigen anwendungstechnischen Eigenschaften. Im Gegenteil besitzen die erfindungsgemäßen Materialien vielfach sogar etwas bessere Belichtungseigenschaften. Darüber hinaus wird mit den erfindungsgemäßen photopolymerisierbaren Aufzeichnungsmaterialien überraschenderweise auch das Restschicht-Problem überwunden, d.h. die aus den erfindungsgemäßen photopolymerisierbaren Aufzeichnungsmaterialien hergestellten, bildmäßig belichteten und entwickelten Schichten lassen sich von dem Substrat auch nach längerer Zeit wieder vollständig und ohne Rückstand durch Strippen mit einem Lösungsmittel entfernen. Dies ist insbesondere für die Verwendung als Photoresist, z.B. bei der Herstellung von Leiterplatten und integrierten Schaltungen, von großer Bedeutung.

Die Erfindung wird durch die nachfolgenden Beispiele näher erläutert. Die in den Beispielen und Vergleichsversuchen genannten Teile und Prozente beziehen sich, sofern nicht ander angegeben, auf das Gewicht.

Beispiele 1 bis 6

Unter Rühren wird aus folgenden Bestandteilen eine homogene Mischung hergestellt:

| | |
|---|---|
| 250 Teile | Essigester/Methanol 1:1 |
| 40 Teile | eines Methacryloyl-Gruppen und freie Carbonsäure-Gruppen enthaltenden Oligomeren, hergestellt aus Bisphenol A-bis-glycidylether, Phthalsäureanhydrid und Glycidylmethacrylat, |
| 13,4 Teile | Trimethylolpropantriacrylat |
| 11 Teile | Hexandiol-bis-glycidylether-bis-methacrylat, |
| 29 Teile | eines Polymeren aus 60 % Methylmethacrylat, 30 % N-Vinyl-pyrrolidon und 10 % Methacrylsäure, |
| 3,4 Teile | Benzophenon |
| 0,1 Teile | Sensibilisator |
| 0,5 Teile | Leukokristallviolett |
| 2,5 Teile | Photooxidans |
| 0,05 Teile | Sicomet-Patentblau |

Nach Filtration durch ein Druckfilter wird die Lösung in einer solchen Schichtstärke auf ein Kupferblech gegossen, daß nach dem Ablüften des Lösungsmittels und Trocknen eine Trockenschichtdicke von 38µm resultierte. Dann wurde die Extinktion der Schicht gemessen.

Zur Herstellung eines Resistmusters wurde die photopolymerisierbare Resistschicht in einem Flachbelichter 30 Sekunden durch ein photographisches Negativ mit den Zügen von Leiterbahnen mit einer Wellenlänge von 360 nm belichtet und anschließend die nicht belichteten Schichtbereiche mit einer wäßrigen Sodalösung ausgewaschen.

Die freigelegten Bereiche des Kupferblechs wurden in einem marktüblichen Ätzbad geätzt. Anschließend konnte die Resistschicht - selbst nach 3 Tagen - vollständig und ohne Restbelag von dem Kupfersubstrat durch Strippen mit 3 %iger KOH-Lösung bei 50 ° C entfernt werden.

Es wurde die optische Dichte (OD) der Mischung vor und nach der Belichtung bei 590 nm gemessen:

| Beispiel | Photooxidans | Sensibilisator | Optische Dichte vor der Belichtung | Optische Dichte nach der Belichtung | Δ OD |
|---|---|---|---|---|---|
| 1* | A | D | 0,08 | 0,63 | 0,55 |
| 2 | B | E | 0,10 | 0,73 | 0,63 |
| 3 | B | F | 0,13 | 0,80 | 0,67 |
| 4 | B | D | 0,12 | 0,80 | 0,68 |
| 5 | C | D | 0,08 | 1,10 | 1,02 |
| 6 | C | G | 0,07 | 1,06 | 0,99 |

* Zum Vergleich aus DOS 31 35 399

Photooxidantien

A: 1-Methoxy-2-picolinium-p-toluolsulfonat

B: 1-(Isobutoxycarbonyloxy)-2-picolinium-chlorid

C: 1-(N,N-Dimethylcarbamoyloxy)-pyridinium-chlorid

Sensibilisatoren

D: Bis-(4-dimethylamino)-benzophenon

E: 4-Dimethylaminophenyl-2,6-diphenyl-pyridin

F: 2-(4'-Dimethylaminophenyl)-4,5-diphenyl-1,2,3-triazol

G: 2-(Dimethylaminophenyl)-benzthiazol

Beispiel 7 (Vergleichsversuch A)

Es wurde analog zu Beispiel 1 gearbeitet, jedoch diesmal als Photooxidationsmittel 2,5 Teile 2,5-Dichlor-1,4-bis(dichlormethyl)benzol eingesetzt. In diesem Fall nahm die bei 590 nm gemessene Extinktion der Aufzeichnungsschicht durch die Belichtung von 0,09 auf 0,61 zu, d.h. die Extinktionsänderung betrug lediglich 0,52, entsprechend einer geringeren Vertiefung der Farbintensität. Ferner konnte in diesem Fall das erzeugte Resistmuster nach 3 Tagen nicht mehr von dem Kupferblech ohne Restbelag gestrippt werden.

Beispiel 8

Es wurde eine homogene Mischung aus folgenden Bestandteilen hergestellt:

| | |
|---|---|
| 250 Teile | Essigester |
| 17 Teile | Trimethylolpropantriacrylat |
| 18 Teile | des äquimolaren Umsetzungsproduktes von Bisphenol A-bis-glycidylether mit Acrylsäure |
| 53 Teile | Polymethylmethacrylat mit einem mittleren Molekulargewicht (Gewichtsmittel) von 153 000, |
| 3,4 Teile | Benzophenon |
| 0,13 Teile | 2-(4′-Dimethylaminophenyl)-4,5-diphenyl-1,2,3-triazol |
| 0,5 Teile | Kristallviolett-Leukobase |
| 2,0 Teile | (N,N-Dimethylcarbamoyloxy)-pyridinium-chlorid |
| 0,03 Teile | Sicomet-Patentblau |
| 5,94 Teile | Triethylenglykoldiacetat. |

Diese Lösung wurde zunächst auf eine Polyester-Folie gegossen, so daß nach dem Abkühlen des Lösungsmittels und Trocknen eine Trockenschichtdicke von 35µm resultierte. Die Extinktion (590 nm) der Schicht betrug 0,12.

Für die Herstellung eines Resistmusters wurde die photopolymerisierbare Resistschicht bei 110 °C auf ein kupferkaschiertes Leiterplattensubstrat auflaminiert, durch ein photographisches Negativ 30 Sekunden in einem Flachbelichter mit aktinischem Licht einer Wellenlänge von 360 nm belichtet; anschließend wurden nach Entfernung der Polyesterfolie die unbelichteten Schichtanteile mit 1,1,1-Trichlorethan ausgewaschen. Durch die Belichtung wurde eine starke Vertiefung der Farbintensität in der Schicht bewirkt, wobei sich die Extinktion der Schicht bei 590 nm um 0,72 auf 0,84 änderte. Das erzeugte Resistmuster konnte auch nach 3tägiger Lagerung anstandslos und ohne Verbleiben eines Restbelages mit Methylenchlorid von dem Substrat gestrippt werden.

Beispiel 9 (Vergleichsversuch B)

Es wurde wie in Beispiel 8 gearbeitet, jedoch wurden diesmal bei der Herstellung der Mischung anstelle der 2 Teile des (N,N-Dimethylcarbamoyloxy)-pyridiniumchlorid 3 Teile 2,5-Dichlor-1,4-bis-(dichlormethyl)-benzol eingesetzt; gleichzeitig wurde der Anteil des Triethylenglykoldiacetats von 5,94 Teilen auf 4,94 Teile reduziert. Bei gleicher Extinktion (590 nm) der unbelichteten Resistschicht wurde diesmal durch die Belichtung lediglich eine Extinktionszunahme von 0,2 gemessen. Der Farbkontrast zwischen belichteten und unbelichteten Bereichen war deutlich schwächer als im Beispiel 8. Außerdem war das erzeugte Resistmuster nach 3 Tagen nicht mehr von dem Substrat strippbar.

Beispiele 10 bis 15

Beispiel 8 wurde wiederholt, wobei jedoch anstelle von (N,N-Dimethylcarbamoyloxy)-pyridiniumchlorid die in der nachfolgenden Tabelle 1 angeführten Photooxidationsmittel in einer Menge von jeweils 2 Teilen eingesetzt wurden. Die Extinktionen (590 nm) der unbelichteten photopolymerisierbaren Resistschichten entsprachen der von Beispiel 8. Die durch die bildmäßige Belichtung erzielte Extinktionänderung (Δ E) bei 590 nm, welche die Vertiefung der Farbintensität sowie bei Bezug auf die Untergrundextinktion in den unbelichteten Bereichen den durch die Belichtung erzielten Farbkontrast anzeigt, ist ebenfalls in der Tabelle 1 wiedergegeben. Die erzeugten Resistmuster waren in allen Fällen auch nach mehrtägiger Lagerung ohne Zurückbleiben eines Restbelages strippbar.

Tabelle 1

| Beispiel | Photooxidationsmittel | Δ E (bei 590 nm) |
|---|---|---|
| 10 | 1-Ethoxy-2-picolinium-tosylat* | 0,51 |
| 11 | 1-Methoxy-2,6-dimethylpyridinium-tetrafluoroborat* | 0,56 |
| 12 | 1-(Isobutoxycarbonyloxy)-2-picoliniumchlorid | 0,81 |
| 13 | 1-(α,α,α-Trichlorethoxycarbonyloxy)pyridiniumchlorid | 0,79 |
| 14 | 1-(N-Morpholinocarbonyloxy)-pyridiniumhexafluorophosphat | 0,72 |
| 15 | 1-(Trifluormethylsulfonyloxy)-pyridinium-trifluormethansulfonat | 0,68 |

* Zum Vergleich aus DOS 31 35 399

Beispiele 16 bis 21

Beispiel 8 wurde wiederholt, wobei diesmal jedoch anstelle des 2-(4'-Dimethylaminophenyl)-4,5-diphenyl-1,2,3-triazols die in der nachfolgenden Tabelle 2 angeführten Sensibilisatoren in einer Menge von jeweils 0,13 Teilen eingesetzt wurden. Durch jeweils 1-minütige bildmäßige Belichtung der Resistschichten wurden die in der Tabelle 2 angegebenen Extinktionsänderungen (Δ OD) bei 590 nm in den belichteten Bereichen erzielt.

Tabelle 2

| Beispiel | Sensibilisator | | Δ OD (bei 590 nm) |
|---|---|---|---|
| 16 | 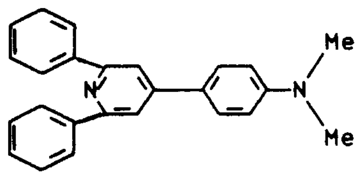 | (E) | 0,71 |
| 17 | 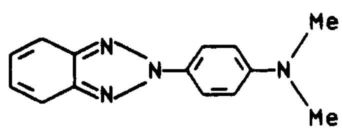 | (F) | 0,80 |
| 18 | 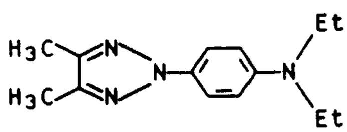 | | 0,83 |
| 19 | 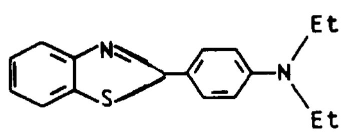 | (G) | 0,88 |

Tabelle 2

| Beispiel | Sensibilisator | Δ OD (bei 590 nm) |
|---|---|---|
| 20 | 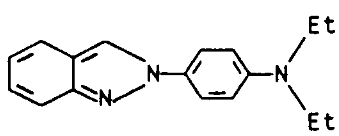 | 0,65 |
| 21 | 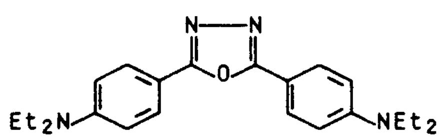 | 0,74 |

## Patentansprüche

1. Photopolymerisierbare Aufzeichnungsmaterialien mit mindestens einer photopolymerisierbaren, olefinisch ungesättigten organischen Verbindung, gegebenenfalls einem polymeren Bindemittel, mindestens einem photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und Hilfsstoffen, die als farbbildendes System
   (a) mindestens eine farblose oder praktisch farblose organische Verbindung, die zu einer farbigen Verbindung oxidierbar ist, und
   (b) als Photooxidationsmittel für die farblose oder praktisch farblose organische Verbindung (a) ein organisches Salz eines, gegebenenfalls substituierten, stickstoffhaltigen heteroaromatischen Systems mit mindestens einer Gruppierung der allgemeinen Formel (I)

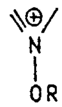 (I)

enthalten,
dadurch gekennzeichnet, daß in dem als Photooxidationsmittel (b) einzusetzenden organischen Salz mit einem, gegebenenfalls substituierten, heteroaromatischen System mit der Gruppierung der allgemeinen Formel (I) R einen gegebenenfalls substituierten Alkenyl-, Alkinyl-, Hetaryl-, Alkenylcarbonyl-, Alkincarbonyl-, Alkoxycarbonyl-, Carbamoyl-, Alkylsulfonyl-, Arylsulfonylaminosulfinyl-Rest oder einen substituierten Cycloalkyl-Rest sowie ein gegebenenfalls substituiertes Hetarylkation darstellt, mit der Maßgabe, daß das Maximum der langwelligen Absorptionsbande dieses Salzes unter 400 nm liegt.

**2.** Photopolymerisierbare Aufzeichnungsmaterialien nach Anspruch 1, dadurch gekennzeichnet, daß sie als Photooxidationsmittel (b) ein Salz eines eine Gruppierung der allgemeinen Formel (I) enthaltenden sechsgliedrigen Heteroaromaten mit 1 bis 3 N-Atomen im Ringsystem, der kernsubstituierten Derivate hiervon oder der benzanellierten oder hetarylanellierten Derivate hiervon enthalten.

**3.** Photopolymerisierbare Aufzeichnungsmaterialien nach einem der Ansprüche 1 bis 2, dadurch gekennzeichnet, daß sie als Photooxidationsmittel (b) eine Verbindung der allgemeinen Formel (II)

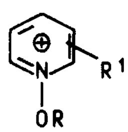 $A^{\ominus}$ (II)

enthalten, worin R die gleiche Bedeutung hat wie in der Gruppierung der allgemeinen Formel (I), $R^1$ steht für Wasserstoff oder eine oder mehrere gegebenenfalls substituierte Alkyl-Gruppen, gegebenenfalls substituierte Phenyl-Gruppen, Alkoxy-Gruppen, Vinyl-Gruppen, Formyl-Gruppen, Nitro-Gruppen oder Halogenatome, wobei über die Reste R oder $R^1$ auch zwei Verbindungen der Formel (II) miteinander verbunden sein können, und $A^{\ominus}$ steht für das Anion einer anorganischen oder organischen Säure mit der Maßgabe, daß kein Anion $A^{\ominus}$ vorhanden ist, wenn einer der Reste R oder $R^1$ einen eine anionische Gruppierung tragenden Rest darstellt.

**4.** Photopolymerisierbare Aufzeichnungsmaterialien nach Anspruch 3, dadurch gekennzeichnet, daß in der Verbindung der allgemeinen Formel (II) R eine substituierte Cycloalkylgruppe mit 6 C-Atomen darstellt.

**5.** Photopolymerisierbare Aufzeichnungsmaterialien nach Anspruch 3, dadurch gekennzeichnet, daß in der Verbindung der allgemeinen Formel (II) R eine gegebenenfalls substituierte Alkoxycarbonylgruppe mit 1 bis 6 Kohlenstoffatomen in der Alkoxygruppe darstellt.

**6.** Photopolymerisierbare Aufzeichnungsmaterialien nach Anspruch 3, dadurch gekennzeichnet, daß in der Verbindung der allgemeinen Formel (II) R ein gegebenenfalls gleich oder unsymmetrisch substituierter N,N-Dialkylcarbamoyl-Rest ist, mit der Maßgabe, daß die Substituenten am Stickstoffatom der Carbamoylgruppe auch miteinander zu einem Ring verbunden sein können.

**7.** Photopolymerisierbare Aufzeichnungsmaterialien nach einem der Ansprüche 3 bis 6, dadurch gekennzeichnet, daß in der Verbindung der allgemeinen Formel (II) $R^1$ steht für Wasserstoffatom oder eine oder mehrere gegebenenfalls substituierte Alkylgruppen.

**8.** Photopolymerisierbare Aufzeichnungsmaterialien nach Anspruch 7, dadurch gekennzeichnet, daß in der Verbindung der allgemeinen Formel (II) $R^1$ steht für Wasserstoffatom oder eine oder zwei Methylgruppen.

**9.** Photopolymerisierbare Aufzeichnungsmaterialien nach einem der Ansprüche 1 bis 8, dadurch gekennzeichnet, daß sie als Photooxidationsmittel (b) entweder ein N-Alkoxycarbonyloxy-pyridinium-salz, oder

ein N-Carbamoyloxy-pyridinium-salz enthalten.

**10.** Photopolymerisierbare Aufzeichnungsmaterialien nach einem der Ansprüche 1 bis 8, dadurch gekennzeichnet, daß sie als Photooxidationsmittel (b) entweder ein N-Carbamoyloxy-picolinium-salz oder ein N-Alkoxycarbonyloxy-pyridiniumsalz enthalten.

**11.** Photopolymerisierbare Aufzeichnungsmaterialien nach einem der Ansprüche 1 bis 10, dadurch gekennzeichnet, daß die als Photooxidationsmittel (b) enthaltenen Salze ein Chlorid-, Perchlorat-, ein Benzolsulfonat-, Toluolsulfonat-, Alkylsulfonat-, Tetrafluoroborat-, ein Hexafluorophosphat- oder Trifluormethansulfonat-Anion enthalten.

**12.** Photopolymerisierbare Aufzeichnungsmaterialien nach einem der Ansprüche 1 bis 11, dadurch gekennzeichnet, daß sie als farblose oder praktisch farblose organische Verbindung (a), die zu einer farbigen Verbindung oxidierbar ist, einen Leukofarbstoff, insbesondere einen Triarylmethanfarbstoff in seiner Leukoform, enthalten.

**13.** Photopolymerisierbare Aufzeichnungsmaterialien nach einem der Ansprüche 1 bis 12, dadurch gekennzeichnet, daß sie als Photopolymerisationsinitiator eine aromatische Carbonylverbindung, insbesondere Benzophenon oder ein Benzophenon-Derivat, enthalten.

**14.** Photopolymerisierbare Aufzeichnungsmaterialien nach einem der Ansprüche 1 bis 13, dadurch gekennzeichnet, daß sie als Sensibilisator ein tertiäres aromatisches Amin enthalten, bei dem der die tertiäre Aminogruppe tragende aromatische Ring mit einem weiteren aromatischen oder heteroaromatischen Ring über Konjugation miteinander verbunden ist.

**15.** Photopolymerisierbare Aufzeichnungsmaterialien nach Anspruch 14, dadurch gekennzeichnet, daß sie als Sensibilisator eine Verbindung der allgemeinen Formel (III)

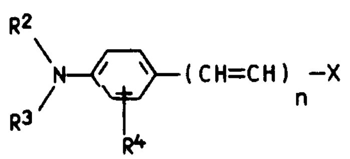

(III)

enthalten, worin
$R^2$ und $R^3$ gleich oder verschieden sein können und stehen für eine gegebenenfalls substituierte Alkylgruppe mit 1 bis 6 Kohlenstoffatomen, eine Phenylgruppe oder eine Aralkyl-Gruppe, $R^2$ und $R^3$ auch miteinander zu einem nicht-aromatischen Ring verbunden sein können, $R^4$ für Wasserstoff oder eine Alkylgruppe steht, X für einen gegebenenfalls substituierten Benzoylrest oder ein gegebenenfalls substituiertes heteroaromatisches Ringsystem steht, und n entweder 0, 1 oder 2 ist.

**16.** Photoresistschichten auf Basis von photopolymerisierbaren Aufzeichnungsmaterialien nach einem der Ansprüche 1 bis 15.

**17.** Flachdruckplatten auf Basis von photopolymerisierbaren Aufzeichnungsmaterialien nach einem der Ansprüche 1 bis 15.

## Claims

**1.** A photopolymerizable recording material composed of one or more photopolymerizable olefinically unsaturated organic compounds, optionally a polymeric binder, one or more photopolymerization initiators, a color-forming system which on irradiation with actinic light causes an increase in the color intensity of the recording material, a sensitizer and optionally further additive or auxiliary substances, which contains as the color-forming system
(a) one or more colorless or virtually colorless organic compounds which are oxidizable to colored compounds, and
(b) as photooxidant for the colorless or virtually colorless organic compound(s) (a) an organic salt of

a substituted or unsubstituted, nitrogen-containing heteroaromatic system containing at least one group of the formula (I)

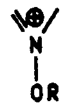

(I)

where, in photooxidant (b) comprising an organic salt of a substituted or unsubstituted heteroaromatic system containing the group of formula (I), R is substituted or unsubstituted alkenyl, alkynyl, hetaryl, alkenylcarbonyl, alkynecarbonyl, alkoxycarbonyl, carbamoyl, alkylsulfonyl or arylsulfonylaminosulfinyl, substituted cycloalkyl or a substituted or unsubstituted hetaryl cation, with the proviso that the maximum of the long-wave absorption band of the salt is below 400 nm.

**2.** A photopolymerizable recording material as claimed in claim 1, wherein photooxidant (b) comprises a salt of a six-membered hetaromatic which has from 1 to 3 nitrogen atoms in the ring system and contains a group of the formula (I), or of a ring-substituted derivative thereof or of a benzo-fused or hetaryl-fused derivative thereof.

**3.** A photopolymerizable recording material as claimed in either of claims 1 or 2, wherein photooxidant (b) comprises a compound of the formula (II)

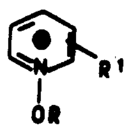

$A^{\ominus}$ (II)

where R has the same meanings as for the group of the formula (I), $R^1$ is hydrogen or one or more substituted or unsubstituted alkyl groups, substituted or unsubstituted phenyl groups, alkoxy groups, vinyl groups, formyl groups, nitro groups or halogen atoms, it also being possible for two compounds of the formula (II) to be connected to each other via R or $R^1$, and $A^{\ominus}$ is the anion of an inorganic or organic acid, with the proviso that no anion $A^{\ominus}$ is present if one of R or $R^1$ is a radical carrying an anionic group.

**4.** A photopolymerizable recording material as claimed in claim 3, wherein in the compound of the formula (II) R is a substituted cycloalkyl of 6 carbon atoms.

**5.** A photopolymerizable recording material as claimed in claim 3, wherein in the compound of the formula (II), R is substituted or unsubstituted alkoxycarbonyl of 1 to 6 carbon atoms in the alkoxy group.

**6.** A photopolymerizable recording material as claimed in claim 3, wherein in the compound of the formula (II) R is optionally identically or asymmetrically substituted N,N-dialkylcarbamoyl, with the proviso that the substituents on the nitrogen atom of the carbamoyl group can also be bonded together to form a ring.

**7.** A photopolymerizable recording material as claimed in any of claims 3 to 6, wherein in the compound of the formula (II) $R^1$ is hydrogen or one or more substituted or unsubstituted alkyl groups.

**8.** A photopolymerizable recording material as claimed in claim 7, wherein in the compound of the formula (II) $R^1$ is hydrogen or one or two methyl groups.

**9.** A photopolymerizable recording material as claimed in any of claims 1 to 8, wherein the photooxidant (b) comprises either an N-alkoxycarbonyloxypyridinium salt or an N-carbamoyloxypyridinium salt.

**10.** A photopolymerizable recording material as claimed in any of claims 1 to 8, wherein photooxidant (b) comprises either an N-carbamoyloxypicolinium salt or an N-alkoxycarbonyloxypyridinium salt.

**11.** A photopolymerizable recording material as claimed in any of claims 1 to 10, wherein the salt present as photooxidant (b) comprises a chloride, perchlorate, benzenesulfonate, toluenesulfonate, alkylsulfonate, tetrafluoroborate, hexafluorophosphate or trifluoromethanesulfonate anion.

**12.** A photopolymerizable recording material as claimed in any of claims 1 to 11, wherein the colorless or virtually colorless organic compound (a) which is oxidizable to a colored compound comprises a leuco dye, in particular a triarylmethane dye in its leuco form.

**13.** A photopolymerizable recording material as claimed in any of claims 1 to 12, wherein the photopolymerization initiator comprises an aromatic carbonyl compound, in particular benzophenone or a benzophenone derivative.

**14.** A photopolymerizable recording material as claimed in any of claims 1 to 13, wherein the sensitizer comprises a tertiary aromatic amine where the aromatic ring carrying the tertiary amino group is connected to a further aromatic or hetaromatic ring via conjugation.

**15.** A photopolymerizable recording material as claimed in claim 14, wherein the sensitizer comprises a compound of the formula (III)

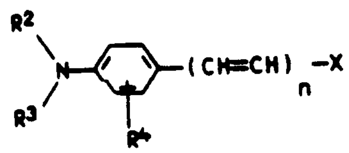

(III)

where $R^2$ and $R^3$ can be identical or different and each is substituted or unsubstituted alkyl of 1 to 6 carbon atoms, phenyl or aralkyl, $R^2$ and $R^2$ can also be bonded together to form a nonaromatic ring, $R^4$ is hydrogen or alkyl, X is substituted or unsubstituted benzoyl or a substituted or unsubstituted hetaromatic ring system, and n is either 0, 1 or 2.

**16.** A photoresist layer based on a photopolymerizable recording material as claimed in any of claims 1 to 15.

**17.** A lithographic printing plate based on a photopolymerizable recording material as claimed in any of claims 1 to 15.

**Revendications**

**1.** Matériaux d'enregistrement photopolymérisables comprenant au moins un composé organique à insaturation oléfinique photopolymérisable, le cas échéant un liant polymère, au moins un inducteur de photopolymérisation, un système chromogène qui, à l'exposition à la lumière actinique, provoque une augmentation de l'intensité de couleur des matériaux d'enregistrement, un sensibilisant et le cas échéant d'autres additifs et produits auxiliaires, ces matériaux contenant en tant que système chromogène

a) au moins un composé organique incolore ou pratiquement incolore oxydable en un composé coloré, et

b) en tant qu'agent photo-oxydant pour le composé organique incolore ou pratiquement incolore (a) un sel organique d'un système hétéroaromatique azoté éventuellement substitué à au moins un groupement de formule générale I

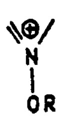

(I)

caractérisé en ce que, dans le sel organique à utiliser en tant qu'agent photo-oxydant (b) à système hétéroaromatique éventuellement substitué, contenant le groupement de formule générale I,

R représente un groupe alcényle-, alcynyle-, hétéroaryle-, alcénylcarbonyle-, alcynecarbonyle-, alcoxycarbonyle-, carbamoyle-, alkylsulfonyle-, arylsulfonylaminosulfinyle éventuellement substitué ou un groupe cycloalkyle substitué ainsi qu'un cation hétéro-arylique éventuellement substitué, sous réserve que le maximum de la bande d'absorption de ce sel dans les grandes longueurs d'ondes soit inférieur à 400 nm.

**2.** Matériaux d'enregistrement photopolymérisables selon la revendication 1, caractérisés en ce qu'ils contiennent en tant qu'agent photo-oxydant b) un sel d'un composé hétéroaromatique à 6 chaînons avec 1 à 3 atomes d'azote dans le système cyclique, contenant un groupement de formule générale I, d'un dérivé d'un tel composé substitué dans le noyau ou d'un dérivé benzocondensé ou hétéroarylocondensé d'un tel composé.

**3.** Matériaux d'enregistrement photopolymérisables selon une des revendications 1 à 2, caractérisés en ce qu'ils contiennnent en tant qu'agent photo-oxydant (b) un composé de formule générale II

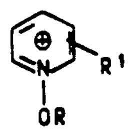 $A^{\ominus}$ (II)

dans laquelle R a les significations indiquées en référence au groupement de formule générale I, $R^1$ représente l'hydrogène ou un ou plusieurs groupes alkyle éventuellement substitués, groupes phényle éventuellement susbtitués, groupes alcoxy, groupes vinyle, groupes formyle, groupes nitro ou atomes d'halogène, deux composés de formule II pouvant également être reliés entre eux par l'intermédiaire des groupes R ou $R^1$ et $A^{\ominus}$ représente l'anion d'un acide minéral ou organique sous réserve que l'anion $A^{\ominus}$ sont absent lorsque l'un des groupes R ou $R^1$ porte un groupement anionique.

**4.** Matériaux d'enregistrement photopolymérisables selon la revendication 3, caractérisés en ce que, dans le composé de formule générale II, R représente un groupe cycloalkyle substitué à 6 atomes de carbone.

**5.** Matériaux d'enregistrement photopolymérisables selon la revendication 3, caractérisés en ce que, dans le composé de formule générale II, R représente un groupe alcoxycarbonyle éventuellement substitué contenant 1 à 6 atomes de carbone dans le groupe alcoxy.

**6.** Matériaux d'enregistrement photopolymérisables selon la revendication 3, caractérisés en ce que, dans le composé de formule générale II, R représente un groupe N,N-dialkylcarbamoyle à substituants éventuellement identiques ou asymétriques, sous réserve que les substituants de l'atome d'azote du groupe carbamoyle puissent également être reliés entre eux avec formation d'un cycle.

**7.** Matériaux d'enregistrement photopolymérisables selon une des revendications 3 à 6, caractérisés en ce que, dans le composé de formule générale II, $R^1$ représente un atome d'hydrogène ou un ou plusieurs groupes alkyle éventuellement substitués.

**8.** Matériaux d'enregistrement photopolymérisables selon la revendication 7, caractérisés en ce que, dans le composé de formule générale II, $R^1$ représente un atome d'hydrogène ou un ou deux groupes méthyle.

**9.** Matériaux d'enregistrement photopolymérisables selon une des revendications 1 à 8, caractérisés en ce qu'ils contiennent en tant qu'agent photo-oxydant (b) soit un sel de N-alcoxycarbonyloxy-pyridinium, soit un sel de N-carbamoyloxy-pyridinium.

**10.** Matériaux d'enregistrement photopolymérisables selon une des revendications 1 à 8, caractérisés en ce qu'ils contiennent en tant qu'agent photo-oxydant (b) soit un sel de N-carbamoyloxy-picolinium, soit un sel de N-alcoxycarbonyloxy-pyridinium.

**11.** Matériaux d'enregistrement photopolymérisables selon une des revendications 1 à 10, caractérisés en

ce que les sels contenus en tant qu'agent photo-oxydant (b) contiennent eux-mêmes un anion chlorure, perchlorate, benzène-sulfonate, toluène-sulfonate, alkylsulfonate, tétrafluoroborate, hexafluorophosphate ou trifluorométhane-sulfonate.

**12.** Matériaux d'enregistrement photopolymérisables selon une des revendications 1 à 11, caractérisés en ce qu'ils contiennent en tant que composé organique incolore ou pratiquement incolore (a), oxydable en un composé coloré, un leuco de colorant, en particulier un colorant de triarylméthane sous sa forme leuco.

**13.** Matériaux d'enregistrement photopolymérisables selon une des revendications 1 à 12, caractérisés en ce qu'ils contiennent en tant qu'inducteur de photopolymérisation un composé aromatique carbonylé, en particulier la benzophénone ou l'un de ses dérivés.

**14.** Matériaux d'enregistrement photopolymérisables selon une des revendications 1 à 13, caractérisés en ce qu'ils contiennent en tant que sensibilisant une amine aromatique tertiaire dans laquelle le cycle aromatique portant le groupe amino tertiaire est relié par conjugaison avec un autre cycle aromatique ou hétéroaromatique.

**15.** Matériaux d'enregistrement photopolymérisables selon la revendication 14, caractérisé en ce qu'ils contiennent en tant que sensibilisant un composé de formule générale III

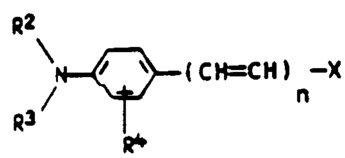

(III)

dans laquelle
$R^2$ et $R^3$, ayant des significations identiques ou différents, représentent chacun un groupe alkyle éventuellement substitué en C1-C6, un groupe phényle ou un groupe aralkyle, $R^2$ et $R^3$ pouvant également être reliés entre eux avec formation d'un cycle non aromatique, $R^4$ représente l'hydrogène ou un groupe alkyle, X représente un groupe benzoyle éventuellement substitué ou un système cyclique hétéroaromatique éventuellement substitué, et n est égal à 0, 1 ou 2.

**16.** Couches de photoréserves à base des matériaux d'enregistrement photopolymérisables selon une des revendications 1 à 15.

**17.** Plaques d'impression à plat à base des matériaux d'enregistrement photopolymérisables selon une des revendications 1 à 15.